(19) Europäisches Patentamt
European Patent Office
Office européen des brevets

(11) **EP 1 938 452 B1**

(12) **FASCICULE DE BREVET EUROPEEN**

(45) Date de publication et mention
de la délivrance du brevet:
**24.04.2013 Bulletin 2013/17**

(21) Numéro de dépôt: **06793082.6**

(22) Date de dépôt: **30.08.2006**

(51) Int Cl.:
***H03G 3/30*** *(2006.01)*

(86) Numéro de dépôt international:
**PCT/EP2006/065838**

(87) Numéro de publication internationale:
**WO 2007/025996 (08.03.2007 Gazette 2007/10)**

(54) **PROCEDE ET DISPOSITIF DE CONTROLE DE 2 NIVEAUX DE PUISSANCE CRETE POUR UN AMPLIFICATEUR EN MODE IMPULSIONNEL**

VERFAHREN UND EINRICHTUNG ZUM STEUERN VON ZWEISPITZEN-LEISTUNGSPEGELN FÜR EINEN VERSTÄRKER IM GEPULSTEN MODUS

METHOD AND DEVICE FOR CONTROLLING TWO PEAK POWER LEVELS FOR A AMPLIFIER IN PULSED MODE

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **30.08.2005 FR 0508877**

(43) Date de publication de la demande:
**02.07.2008 Bulletin 2008/27**

(73) Titulaire: **THALES**
**92200 NEUILLY SUR SEINE (FR)**

(72) Inventeur: **LETEMPLIER, Alain**
**F-53100 Mayenne (FR)**

(74) Mandataire: **Dudouit, Isabelle**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A- 4 237 555     US-A- 5 832 373**
**US-B1- 6 584 303**

- **UPINE F ET AL: "A high efficient LDMOS power amplifier based on an inverse class F architecture" MICROWAVE CONFERENCE, 2004. 34TH EUROPEAN AMSTERDAM, THE NETHERLANDS 13 OCT. 2004, PISCATAWAY, NJ, USA,IEEE, 11 octobre 2004 (2004-10-11), pages 1181-1184, XP010788306 ISBN: 1-58053-992-0**

## Description

L'invention concerne notamment un procédé et un dispositif de contrôle d'au moins 2 niveaux de puissance pour un amplificateur fonctionnant en mode impulsionnel.

L'invention concerne, par exemple, un dispositif de contrôle de puissance crête d'un émetteur de puissance radiofréquence RF impulsionnel large bande pouvant délivrer 2 niveaux de puissance crête appelés puissance normale et puissance réduite.

Pour les émetteurs impulsionnels de puissance devant délivrer une puissance réduite de n dB par application d'un signal discret de commande, il est connu d'employer les méthodes suivantes :

- ajouter en sortie d'un émetteur, un commutateur de puissance mettant ou non en service un atténuateur de n dB,
- ajouter entre 2 étages de basse puissance, un commutateur mettant ou non en service soit un atténuateur de n dB, soit un étage amplificateur de n dB,
- faire varier l'alimentation DC de n étages bipolaires classe C.

Ces dispositifs présentent toutefois certains inconvénients :

Le commutateur de puissance introduit notamment des pertes. L'ampli de puissance doit donc être plus puissant qu'il n'est nécessaire pour son fonctionnement. De fait, il doit toujours fonctionner à une puissance maximale. De plus, l'implantation doit permettre d'intégrer l'atténuateur.

La difficulté de garantir un gain identique des étages suivants pour chacun des 2 niveaux de puissance. Ce problème devient vite insurmontable quand il s'agit d'amplificateur large bande.

La dynamique de variation de puissance est limitée à 2 dB par étage bipolaire classe C.

Un autre amplificateur fonctionnant en mode impulsionnel est proposé dans le brevet américain US 4 237 555.

L'invention concerne un dispositif de contrôle d'au moins 2 niveaux de puissance crête pour un amplificateur fonctionnant en mode impulsionnel comportant au moins les éléments suivants: un étage de pré-modulation comportant au moins :

- un premier étage amplificateur, comprenant au moins un premier amplificateur avec une alimentation de drain impulsionnel, et adapté à fournir un premier signal RF amplifié, ledit premier amplificateur étant contrôlé par un premier signal de modulation généré à partir de deux premières tables numériques adressées en fonction d'une fréquence à émettre (FREQ) et d'un signal commande P normale/Préduite (PNR) par un premier dispositif de traitement, l'amplitude dudit premier signal de modulation étant réglée par un potentiomètre numérique, la forme dudit premier signal étant générée via une source de tension continue (Ref DC), ledit premier signal RF amplifié par ledit premier amplificateur se présentant sous la forme d'impulsions RF de forme carrée, lesdites impulsions étant transmises à :

- un deuxième étage amplificateur, comprenant un second amplificateur avec alimentation de drain ipmulsionnel, le gain dudit second amplificateur étant contrôlé par un second signal de modulation généré par un convertisseur analogique numérique à partir de tables de modulation et à partir de secondes tables numériques sélectionnées par le signal de commande Pnormale/Préduite (PNR), via un premier potentiomètre numérique, ledit potentiel numérique est adapté à faire varier l'amplitude dudit second signal de modulation, le second amplificateur fournissant un signal de sortie se présentant sous la forme d'impulsions RF dont la puissance crête prend 2 valeurs fixes en fonction de la fréquence, ledit signal étant transmis à un étage asservi en puissance,
ledit étage asservi en puissance comportant au moins :
- un amplificateur RF à gain variable recevant le signal de sortie du second amplificateur, le gain dudit amplificateur RF est contrôlé par un troisième signal de modulation résultant du traitement d'un signal RF à la sortie de l'amplificateur RF, la sortie de l'amplificateur RF étant connectée à un coupleur et détecteur ayant une sortie couplée à un amplificateur vidéo dont le gain est contrôlé par un potentiomètre numérique à bus de commande série pour assurer la compensation en fréquence et en température de l'amplificateur RF, une sortie dudit d'amplificateur vidéo est connectée à un détecteur crête ayant une sortie connectée à un discriminateur de niveaux ayant une entrée adaptée à recevoir une valeur de consigne « Ref DC » et une sortie adaptée à transmettre des informations de puissance crête à un dispositif de traitement, ledit dispositif de traitement-asservissement étant adapté à élaborer et à transmettre une commande synchronisée d'incrémentation ou de décrémentation addressée en fonction dudit signal Pnormale/Préduite (PNR) à une première entrée d'un second potentiomètre numérique, ledit second potentiomètre numérique ayant une seconde entrée adaptée à recevoir un signal généré à parir des secondes tables numériques sélectionnées par un discret Pnormale/Préduite identiques à celui utilisé par l'étage précécent et ayant à la sortie ledit troisième signal de modulation.

Selon un mode de réalisation, la puissance de sortie RF est dépendante du gain de l'ampli vidéo, lequel est maîtrisé par sa commande de gain issue d'une table numérisée indexée en fréquence, température et PNR.

$$P_{crête} = \left(\frac{consigne}{A \times K}\right)^2$$

avec

K : qui varie selon la sensibilité en fréquence et en température du système de détection

A : le gain de l'ampli vidéo est contrôlé par le système et élaboré à partir d'une table numérisée indexée en fréquence, température et PNR

la valeur de consigne est réalisée à l'aide d'une référence de tension.

L'invention concerne aussi un procédé pour contrôler ou générer au moins deux niveaux de puissance crête dans une chaîne d'amplification fonctionnant en mode impulsionnel comportant au moins les étapes suivantes :

- élaborer un premier signal de modulation ayant une amplitude contrôlée en utilisant une tension continue variable générée à partir de deux tables numériques, adressées en fonction d'une fréquence à émettre et d'un signal de commande Pnormale/Préduite (PNR), en utilisant une tension continue (Ref DC) afin de produire la forme du premier signal de modulation,

- transmettre ledit premier signal de modulation à un premier amplificateur, afin de produire des impulsions RF de forme carrée, transmettre lesdites impulsions RF de forme carrée à un second amplificateur,

- générer un second signal de modulation ayant une forme sensiblement identique au signal à amplifier et l'appliquer au second amplificateur, ledit second amplificateur recevant lesdites impulsions de forme carrée ou sensiblement carrée issu du premier amplificateur et recevant le second signal de modulation généré par un convertisseur numérique analogique à partir de premières tavies de modulation et recevant une information de l'amplitude dudit troisième signal de modulation à partir de secondes tables sélectionnées par un signal de commande Pnormale/Préduite (PNR) afin de produire en sortie de la deuxième étape un signal se présentant sous la forme d'impulsions RF dont la puissance crête prend 2 valeurs fixes en fonction de la fréquence, ledit signal étant transmis à un étage asservi en puissance comprenant un troisième amplificateur,

- générer un signal de niveau de puissance crête et de largeur contrôlée et l'appliquer au signal issu de la deuxième étape d'amplification se présentant sous la forme d'impulsions RF, ledit signal de niveau de puissance crête et de largeur contrôlée étant un troisième signal de modulation résultant du traitement du signal RF détecté en sortie de amplificateur par un détecteur et transmis à un amplificateur vidéo dont le gain est contrôlé par un potentiomètre numérique à bus de commande série pour assurer la compensation en fréquence et en température de l'ampli RF, le signal en sortie d'ampli vidéo étant transmis à un détecteur crête puis à un discriminateur de niveaux qui transmet à partir d'une valeur de consigne "Ref DC" les informations de puissance crête à un dispositif de traitement-asservissement qui élabore une commande synchronisée d'incrémentation ou de décrémentation en fonction dudit signal Pnormale/Préduite (PNR) et générant à l'aide de ladite commande d'incrémentation ou décrementation et à l'aide des tables de modulation via un potentiomètre numérique ledit troisième signal de modulation.

Le dispositif et le procédé selon l'invention offrent notamment les avantages suivants :

- le système permet de garantir l'intégrité de l'impulsion gaussienne émise, de réguler ses puissances crête avec précision dans toute la bande de fréquence concernée et d'obtenir des performances stables en température,
- des dimensions, poids et volume réduits pour les applications embarquées,
- le système est suffisamment rapide pour assurer une agilité suffisante de la variation de puissance et une dynamique de variation la plus grande possible sans sacrifier la précision.

D'autres caractéristiques et avantages de la présente invention apparaîtront mieux à la lecture de la description qui suit d'un exemple de réalisation donné à titre illustratif et nullement limitatif annexé des figures qui représentent:

- la figure 1 l'architecture d'un dispositif permettant le contrôle de 2 niveaux de puissance crête selon l'invention,
- les figures 2A et 2B différents chronogrammes correspondant aux signaux de commande et aux signaux de modulation,
- la figure 3 une architecture pour un amplificateur commandé en tension pulsé pouvant être utilisé dans le schéma selon l'invention.

Le dispositif et le procédé selon l'invention reposent notamment sur le contrôle de gain de n étages d'une chaîne d'amplification plutôt que sur l'utilisation de dispositifs permettant une atténuation synonyme de pertes inutiles.

L'invention consiste notamment, grâce à une détection du signal émis d'une part et l'utilisation d'un ampli RF à gain variable d'autre part, à générer un signal impulsionnel de forme gaussienne d'amplitude contrôlée par un système d'asservissement numérisé ayant deux niveaux ou plus de puissance crête pouvant être sélectionnés par un signal discret.

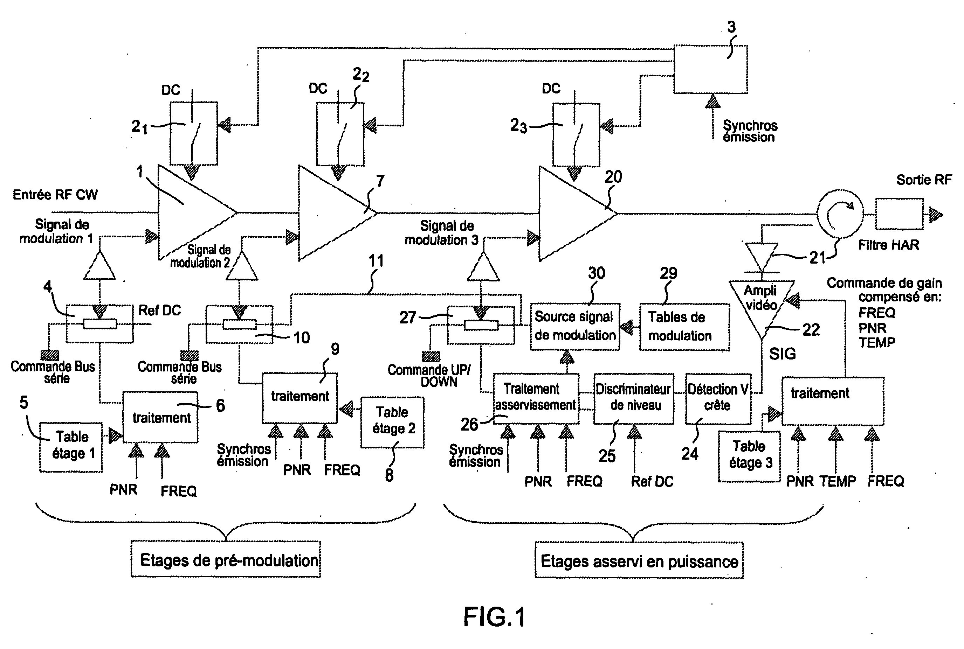

La figure 1 schématise un exemple d'architecture pour le système selon l'invention. Il comprend, par exemple, un étage asservi en puissance et un ou plusieurs étages de pré-modulation. Ces étages sont détaillés ci-après.

Premier étage d'amplification

Le premier étage d'amplification RF utilise par exemple un transistor LDMOS 1 utilisé en classe AB avec alimentation de drain impulsionnel. Pour cela, l'alimentation $2_1$ est reliée à un dispositif de traitement 3 recevant un signal de synchronisation d'émission et émettant une commande en conséquence permettant une alimentation découpée de l'amplificateur.

Le gain du premier étage est contrôlé par une tension continue 4 variable générée à partir de 2 tables numériques stockées, par exemple, en SEPROM 5, destinées à commander un potentiomètre numérique 4 permettant de régler l'amplitude du signal de modulation dont la forme est générée via une source de tension continue référencée DC sur la figure. A chacune des fréquences en puissance réduite et en puissance normale correspond une tension continue. Les 2 tables sont adressées en fonction de la fréquence Freq à émettre et du signal de commande "Puissance normale/Puissance réduite par un dispositif de traitement 6. Le signal de modulation ainsi généré est transmis à l'amplificateur 1.

Il en résulte en sortie de l'ampli RF à gain variable 1, 2 niveaux de puissance crête espacées de la moitié de l'écart de puissance. Chacun des 2 niveaux de puissance est fixe en fonction de la fréquence. Il peut éventuellement incorporer une pré-accentuation si nécessaire.

En sortie de l'amplificateur 1, on obtient des impulsions RF de forme carrée, dont la puissance crête prend 2 valeurs fixes en fonction de la fréquence selon l'état du discret de commande de puissance réduite (PNR). Les impulsions sont transmises à un deuxième amplificateur de puissance.

L'écart entre la puissance maximale et la puissance réduite est limité par le gain inverse de l'étage. Pour conserver une bonne précision et rester dans une dynamique de tension de commande, on cherche la valeur d'écart la plus réduite possible compte tenu des contraintes de bande passante. L'écart maximum qui peut être atteint est par exemple limité à 7 à 8 dB.

Deuxième étage d'amplification

Le second étage d'amplification RF utilise par exemple un transistor LDMOS 7 utilisé en classe AB avec alimentation de drain impulsionnel $2_2$. Le gain de l'étage est contrôlé par une tension modulée d'amplitude variable.

Cet étage est utilisé si l'écart entre les 2 niveaux de puissance présents sur l'entrée du transistor excède 7 à 8 dB.

L'information d'amplitude maximum du signal de modulation est générée à partir de n*2 tables numériques stockées en SEPROM 8 adressées en fonction de la fréquence à émettre et du discret Pnormale/Préduite, n étant adressé en fonction du résultat de mesure de la largeur à mi-amplitude de l'impulsion émise, le signal produit est donc aussi contrôlé en largeur. Un dispositif de traitement 9 reçoit les signaux de synchronisation émission, le PNR et la fréquence requise Freq à émettre.

La forme du signal de modulation est générée via un convertisseur analogique numérique DAC (source de modulation) 30 à partir de n*2 tables numériques sélectionnées par le signal de commande Pnormale/Préduite. Il est synchronisé par les commandes d'émission. Le potentiomètre 10 permet de faire varier l'amplitude du signal de modulation (signal de modulation 2).

Ce signal de modulation est le même ou sensiblement le même que celui utilisé par l'étage asservi en puissance. La modulation sur 2 étages successifs permet notamment de conserver l'intégrité des impulsions à émettre au voisinage de leur pied. L'utilisation de n*2 tables différentes selon le niveau de puissance est associée à la non linéarité des courbes de gain des étages amplificateurs LDMOS.

Il en résulte en sortie du deuxième étage d'amplification, (en sortie de l'amplificateur 7), 2 niveaux de puissance crête en sortie espacés de la totalité de l'écart de puissance nécessaire. Chacun des 2 niveaux de puissance est fixe en fonction de la fréquence. Il peut éventuellement incorporer une pré-accentuation si nécessaire.

En sortie du deuxième étage d'amplification, on obtient donc des impulsions RF de forme correspondant à la modulation appliquée (modulation par la polarisation de grille du transistor) et dont la puissance crête peut prendre 2 valeurs fixes en fonction de la fréquence selon l'état du discret de commande de puissance réduite (PNR). La largeur est contrôlée par la maîtrise du signal de modulation.

Etage asservi en puissance

L'étage de puissance comporte notamment :

un amplificateur RF à gain variable 20,
un coupleur et un détecteur référencés 21 stabilisés notamment en température.

Le signal détecté $k \times \sqrt{P_{crête}}$ est appliqué à un ampli vidéo 22 dont le gain est contrôlé par un potentiomètre numérique à bus de commande série pour assurer la compensation en fréquence et en température de l'ampli RF. En outre l'ampli vidéo 22 a 2 plages de réglage de gain en fonction de la commande de puissance réduite (PNR).

Un détecteur crête 24 et un discriminateur 25 de niveaux envoient à partir d'une valeur de consigne "Ref DC" les informations de puissance crête à un dispositif de traitement-asservissement 26 qui élabore une commande synchronisée d'incrémentation ou de décrémentation d'un potentiomètre numérique 27 à interface UP/DOWN générant ainsi le signal de modulation de l'étage RF à partir du signal de modulation généré via un convertisseur DAC 28 à partir de 2 tables numériques sélectionnées par le discret Pnormale/Préduite (identique à celui utilisé par l'étage précédent).

La puissance de crête de sortie est ainsi asservie pulse par pulse à une valeur telle que le signal détecté en sortie d'ampli vidéo 22 soit égal ou sensiblement égal à la valeur de consigne. La puissance de sortie RF dépend notamment du gain de l'ampli vidéo, lequel est maîtrisé par sa commande de gain issue d'une table 29 numérisée indexée en fréquence, température et PNR.

$$P_{crête} = \left( \frac{consigne}{A \times K} \right)^2$$

avec

K : qui varie selon la sensibilité en fréquence et en température du système de détection et éventuellement des éléments (circulateur, filtre HAR etc.) hors boucle d'asservissement intercalés entre le coupleur de prélèvement de la puissance de sortie (21) et la sortie RF de l'ampli vidéo.

A : le gain de l'ampli vidéo est contrôlé par le système et élaboré à partir d'une table numérisée indexée en fréquence, température et PNR. Il compense l'effet de K. Pour que Pcrête soit constant, Il faut que le produit A K soit constant.

La valeur de consigne : réalisée à l'aide d'une référence de tension.

Le discriminateur de niveaux va élaborer 2 informations P trop forte et P trop faible à partir de 2 valeurs seuils MAX et MIN (fraction de la tension de référence). L'écart de tension entre MAX et MIN va créer l'hystérésis nécessaire pour faire converger l'asservissement et déterminer ainsi la précision de l'asservissement.

L'étage de pré-modulation contrôlé en rapport de puissance sur bruit PNR permet d'obtenir des signaux modulant de l'étage asservi très voisin, que l'on soit en P normale ou en P réduite car le gain de l'étage RF asservi reste quasi constant. Ceci permet d'obtenir un temps de passage de puissance normale vers puissance réduite et inversement minimum sachant que ce dernier dépend du nombre d'impulsions à émettre et de la valeur d'un pas de correction du potentiomètre de contrôle du niveau de modulation.

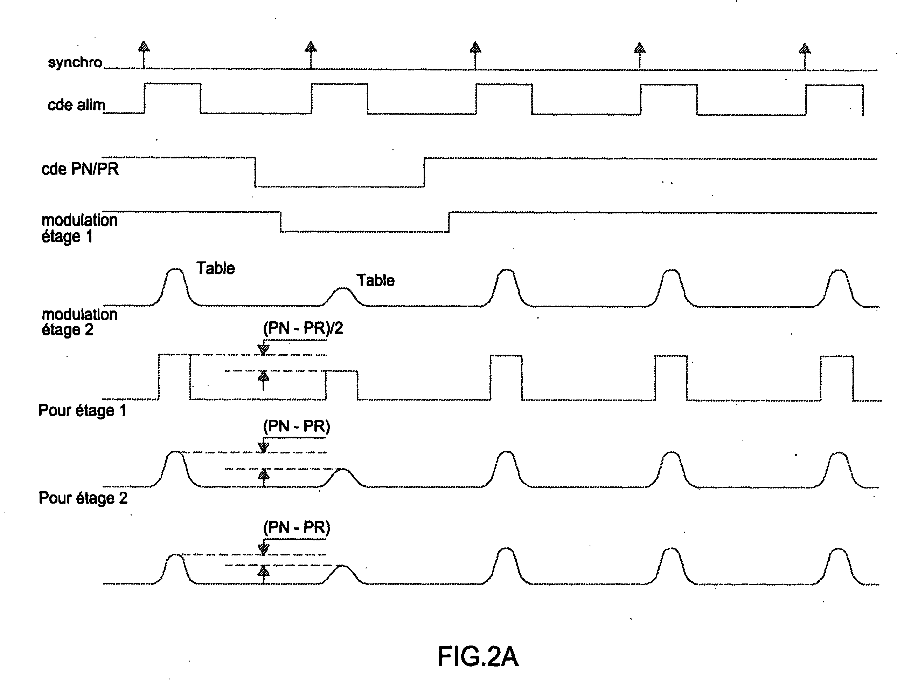

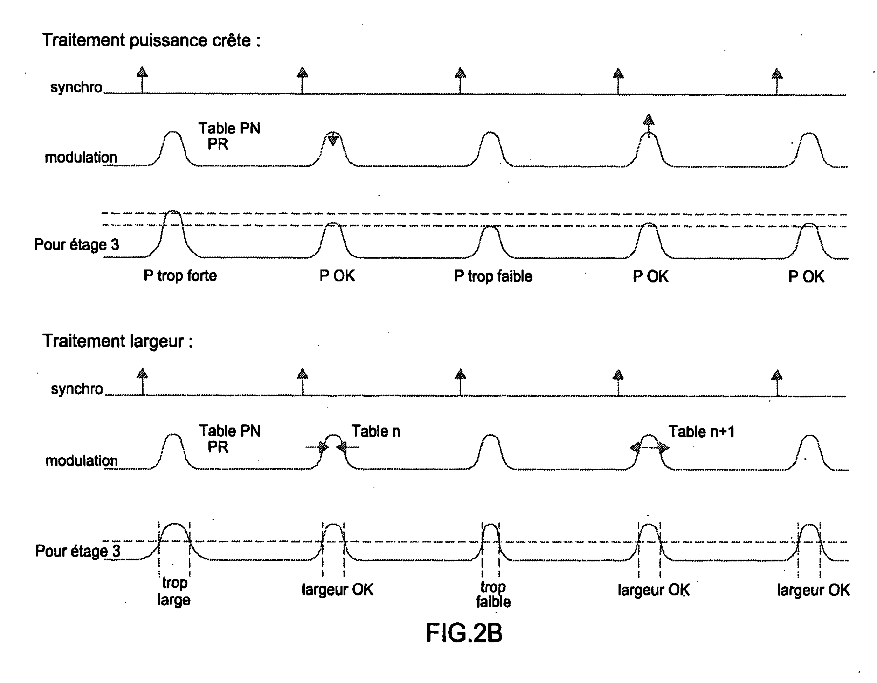

Les figure 2A et 2B représentent les chronogrammes des signaux de commande et de modulation en divers points de la chaîne d'amplification.

En partant du haut, on a représenté selon l'axe des temps :

Pour les traitements PN/PR

le signal de synchronisation,
la commande alimentation des différents transistors de la chaîne,
la commande PN/PR,
le signal de modulation du premier étage,
le signal de modulation du deuxième étage,
la puissance obtenue en sortie du premier étage,
la puissance obtenue en sortie du deuxième étage,

Pour le traitement puissance crête

le signal de synchronisation,
le signal de modulation,
la puissance en sortie de l'étage 3,

Pour le traitement largeur

le signal de synchronisation,
le signal de modulation,
la puissance de sortie d'étage 3.

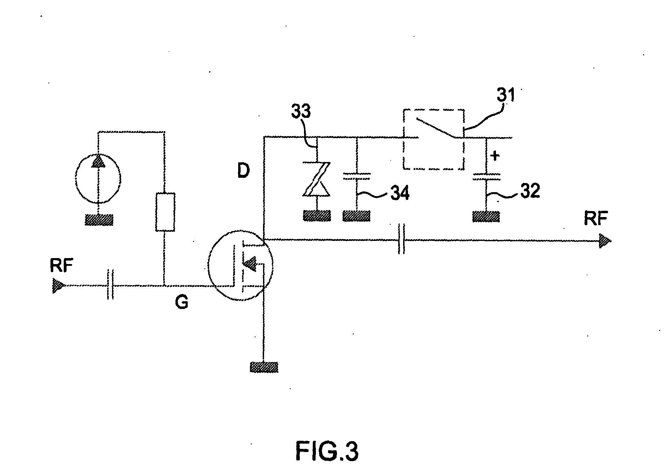

La figure 3 représente un transistor LDMOS fonctionnant en régime impulsionnel en amplification RF de puissance.

La grille G du transistor reçoit le signal modulé en fréquence et est alimentée par une alimentation de grille. Le drain D est relié à une alimentation DC au moyen d'un commutateur 31 faible perte. Le commutateur 31 est commandé au moyen du signal de synchronisation sync d'émission du signal modulé. Le courant de drain n'est présent que lorsque le drain est alimenté. Un dispositif d'écrêtage bi-directionnel rapide de tension, 33, valeur comprise entre l'alimentation crête du drain et la tension de claquage drain source du transistor LDMOS, offre une protection efficace contre les surtensions inhérentes à ce type de fonctionnement. La capacité 34 permet un découplage RF.

L'énergie instantanée nécessaire est fournie par une capacité réservoir 32 de forte valeur calculée en fonction du taux de charge de l'émetteur et faible résistance en série. La capacité est choisie afin de minimiser les pertes.

Le commutateur faible perte est réalisé par exemple à partir de transistors MOSPOWER. Il est donc facilement réalisable et offre toutes les qualités de tenue au courant de drain crête élevé et de faibles pertes L'alimentation VG de la grille peut être :

- une tension continue variable de commande de gain, par exemple un ampli à gain variable,

- un signal de modulation pour un étage utilisé comme un modulateur.

La tension de grille est contrôlable en amplitude, ajustage du courant de drain de repos, ajustage du gain RF de l'étage.

## Revendications

1. Dispositif de contrôle d'au moins 2 niveaux de puissance crête pour un amplificateur fonctionnant en mode impulsionnel comportant au moins les éléments suivants :

   un étage de pré-modulation comportant au moins :

   • un premier étage amplificateur, comprenant au moins un premier amplificateur (1) avec une alimentation de drain impulsionnel ($2_1$) et adapté à fournir un premier signal RF amplifié, le gain du premier amplificateur (1) étant contrôlé par un premier signal de modulation généré à partir de deux premières tables numériques (5) adressées en fonction d'une fréquence à émettre (FREQ) et d'un signal de commande Pnormale/Préduite (PNR) par un premier dispositif de traitement (6), l'amplitude dudit premier signal de modulation étant réglée par un potentiomètre numérique (4), la forme dudit premier signal étant générée via une source de tension continue (DC), ledit premier étage amplificateur comprenant une entrée adaptée à recevoir ledit signal de modulation (1), ledit premier signal RF amplifié par ledit premier amplificateur (1) se présentant sous la forme d'impulsions RF de forme carrée, lesdites impulsions étant transmises à:
   • un second étage amplificateur, comprenant un second amplificateur (7) avec alimentation de drain ipmulsionnel ($2_2$), le gain du second amplificateur (7) étant contrôlé par un second signal de modulation généré par un convertisseur numérique analogique (30) à partir de tables de modulation (29) et à partir de secondes tables numériques (8) sélectionnées par le signal de commande Pnormale/Préduite (PNR), via un premier potentiomètre numérique (10), ledit potentiomètre numérique (10) étant adapté à faire varier l'amplitude dudit second signal de modulation, le second amplificateur (7) fournissant un signal de sortie se présentant sous la forme d'impulsions RF dont la puissance crête prend 2 valeurs fixes en fonction de la fréquence, lesdites impulsions RF étant transmises à un étage asservi en puissance,

   ledit étage asservi en puissance comportant au moins :

   • un amplificateur RF (20) à gain variable adapté à recevoir le signal de sortie dudit second amplificateur (7), le gain dudit amplificateur RF (20) étant contrôlé par un troisième signal de modulation résultant d'un traitement d'un signal RF à la sortie de l'amplificateur RF (20), la sortie dudit amplificateur RF(20) étant connectée à un coupleur et détecteur (21) ayant une sortie couplée à un amplificateur vidéo (22) dont le gain est contrôlé par un potentiomètre numérique à bus de commande série afin d'assurer la compensation en fréquence et en température de amplificateur RF (20), une sortie dudit amplificateur vidéo (22) est connectée à un détecteur crête (24) ayant une sortie connectée à un discriminateur (25) de niveaux ayant une entrée adaptée à recevoir une valeur de consigne "Ref DC" et une sortie adaptée à transmettre les informations de puissance crête à un dispositif de traitement-asservissement (26), ledit dispositif de traitement-asservissement étant adapté à élaborer et à transmettre une commande synchronisée d'incrémentation ou de décrémentation adressée en fonction dudit signal Pnormale/Préduite (PNR) à une première entrée d'un second potentiomètre numérique (27), ledit second potentiomètre numérique (27) ayant une seconde entrée adaptée à recevoir un signal de modulation généré à partir des tables de modulation (29) sélectionnées par un discret Pnormale/Préduite identique à celui utilisé par l'étage précédent et ayant à la sortie ledit troisième signal de modulation.

2. Dispositif selon la revendication 1 **caractérisé en ce que** la puissance de sortie RF est dépendante du gain de amplificateur vidéo, lequel est maîtrisé par sa commande de gain issue d'une table (29) numérisée en fréquence, température et PNR

$$P_{crête} = \left(\frac{consigne}{A \times K}\right)^2$$

avec

K : qui varie selon la sensibilité en fréquence et en température du système de détection
A : le gain de l'ampli vidéo (22) contrôlé par le système et élaboré à partir d'une table numérisée indexée en fréquence, température et PNR,
La valeur de consigne étant réalisée à l'aide d'une référence de tension.

3. Dispositif selon la revendication 1 **caractérisé en ce que** le premier étage d'amplification comprend un transistor LDMOS utilisé en classe AB avec une alimentation de drain impulsionnel.

4. Dispositif selon la revendication 1 **caractérisé en ce que** le deuxième étage d'amplification comprend un transistor LDMOS utilisé en classe AB avec alimentation de drain impulsionnel.

5. Dispositif selon la revendication 1 **caractérisé en ce que** le gain du second étage amplificateur est contrôlé par une tension modulée d'amplitude variable.

6. Procédé pour contrôler ou générer au moins deux niveaux de puissance crête dans une chaîne d'amplification fonctionnant en mode impulsionnel, ladite chaîne d'amplification comprenant un premier étage amplificateur et un second étage amplificateur comportant au moins les étapes suivantes :

  • élaborer un premier signal de modulation ayant une amplitude contrôlée en utilisant une tension continue variable générée à partir de deux tables numériques (5), adressées en fonction d'une fréquence à émettre et d'un signal de commande Pnormale/Préduite (PNR), en utilisant une tension continue (Ref DC) afin de produire la forme du premier signal de modulation,
  • transmettre ledit premier signal de modulation à un premier amplificateur (1), afin de produire des impulsions RF de forme carrée, transmettre lesdites impulsions RF de forme carrée à un second amplificateur (7),
  • générer un second signal de modulation ayant une forme sensiblement identique au signal à amplifier et l'appliquer au second amplificateur (7), ledit second amplificateur (7) recevant lesdites impulsions de forme carrée ou sensiblement carrée issu du premier amplificateur (1) et recevant le second signal de modulation généré par un convertisseur numérique analogique (30) à partir de premières tables de modulation (29) et recevant une information de l'amplitude dudit second signal de modulation à partir de secondes tables (8) sélectionnées par un signal de commande Pnormale/Préduite (PNR) afin de produire en sortie du second amplificateur (7) un signal se présentant sous la forme d'impulsions RF dont la puissance crête prend 2 valeurs fixes en fonction de la fréquence, ledit signal étant transmis à un étage asservi en puissance comprenant un troisième amplificateur (20),
  • générer un signal de niveau de puissance crête et de largeur contrôlée et l'appliquer au signal issu de la deuxième étape d'amplification se présentant sous la forme d'impulsions RF, ledit signal de niveau de puissance crête et de largeur contrôlée étant un troisième signal de modulation résultant du traitement du signal RF détecté en sortie de l'amplificateur (20) par un détecteur (21) et transmis à un amplificateur vidéo (22) dont le gain est contrôlé par un potentiomètre numérique à bus de commande série pour assurer la compensation en fréquence et en température de l'amplificateur RF, le signal en sortie d'amplificateur vidéo (22) étant transmis à un détecteur crête (24) sortie crête puis à un discriminateur (25) de niveaux qui transmet a partir d'une valeur de consigne "Ref DC" les informations de puissance crête à un dispositif de traitement-asservissement (26) qui élabore une commande synchronisée d'incrémentation ou de décrémentation en fonction dudit signal Pnormale/Préduite (PNR) et générant à l'aide de ladite commande d'incrémentation ou décrémentation et à l'aide des tables de modulation (29) via un potentiomètre numérique (27) le troisième signal de modulation

7. Procédé selon la revendication 6 **caractérisé en ce que** la puissance de sortie RF est dépendante du gain de l'amplificateur vidéo, lequel est maîtrisé par sa commande de gain issue d'une table (29) numérisée indexée en fréquence, température et PNR.

$$P_{crête} = \left(\frac{consigne}{A \times K}\right)^2$$

avec
K : qui varie selon la sensibilité en fréquence et en température du système de détection
A : le gain de l'ampli vidéo (22) est contrôlé par le système et élaboré à partir d'une table numérisée indexée en fréquence, température et PNR
la valeur de consigne est réalisée à l'aide, d'une référence de tension.

**Claims**

1. A device for controlling at least two peak power levels for an amplifier operating in a pulsed mode, comprising at least the following elements:

  a pre-modulation stage comprising at least:

    • a first amplification stage, comprising at least one first amplifier (1) with a pulsed drain supply ($2_1$) and designed to provide a first amplified RF signal, the gain of said first amplifier (1) being controlled by a first modulation signal generated from two first digital tables (5) addressed as a function of a frequency to be transmitted (FREQ) and a Pnormal/Preduced control signal (PNR) by a first processing device (6), the amplitude of said first modulation signal being regulated by a digital potentiometer (4), the form of said first signal being generated via a DC voltage source (DC), said first amplification stage comprising an input that is designed to receive said modulation signal (1), said first RF signal amplified by said first amplifier (1) having the form of square shaped RF pulses, said pulses being transmitted to:

• a second amplification stage, comprising a second amplifier (7) with a pulsed drain supply ($2_2$), the gain of said second amplifier (7) being controlled by a second modulation signal generated by a digital-analogue converter (30) generated from modulation tables (29) and generated from second digital tables (8) selected by the Pnormal/Preduced control signal (PNR) via a first digital potentiometer (10), said digital potentiometer (10) being designed to vary the amplitude of said second modulation signal, said second amplifier (7) providing an output signal having the form of RF pulses, the peak power of which has two fixed values as a function of the frequency, said RF pulses being transmitted to a power controlled stage,

said power controlled stage comprising at least:

• one variable gain RF amplifier (20) that is designed to receive the output signal generated from said second amplifier (7), the gain of said RF amplifier (20) being controlled by a third modulation signal resulting generated from the processing of an RF signal at the output of said RF amplifier (20), the output of said RF amplifier (20) being connected to a coupler and detector (21) having an output that is coupled to a video amplifier (22), the gain of which is controlled by a digital potentiometer with a series control bus so as to ensure the frequency and temperature compensation of the RF amplifier (20), an output of said video amplifier (22) is connected to a peak detector (24) having an output connected to a level discriminator (25) having an input that is designed to receive a set point value "Ref DC" and an output that is designed to transit the peak power information to a processing-control device (26), said processing-control device being designed to develop and to transmit a synchronised incrementation or decrementation command that is addressed as a function of said Pnormal/Preduced signal (PNR) to a first input of a second digital potentiometer (27), said second digital potentiometer (27) having a second input that is designed to receive a modulation signal that is generated from modulation tablet (29) selected by a discreet Pnormal/Preduced signal that is identical to that used by the preceding stage and having said third modulation signal at the output.

2. The device according to claim 1, **characterised in that** the output power is dependent on the gain of said video amplifier, which is controlled by its gain command taken from a table (29) digitised in terms of frequency, temperature and PNR,

$$P_{peak} = \left( \frac{\text{setpoint}}{A \times K} \right)^2$$

wherein K: varies according to the frequency and temperature sensitivity of the detection system ;
A: is the video amplifier gain (22) controlled by the system and developed on the basis of a digitised table that is indexed by frequency, temperature and PER,
the setpoint value being determined using a voltage reference.

3. The device according to claim 1, **characterised in that** the first amplification stage comprises an LDMOS transistor that is used in category AB with a pulsed drain supply.

4. The device according to claim 1, **characterised in that** the second amplification stage comprises an LDMOS transistor that is used in category AB with a pulsed drain supply.

5. The device according to claim 1, **characterised in that** the gain of the second amplification stage is controlled by a variable amplitude modulated voltage.

6. A method for controlling or generating at least two peak power levels in an amplification chain operating in pulsed mode, said amplification chain comprising a first amplification stage and a amplification comprising at least the following steps:

• developing a first modulation signal having an amplitude that is controlled by using a variable DC voltage that is generated on the basis of two digital tables (5), addressed as a function of a frequency to be transmitter and a Pnormal/Preduced control signal (PNR), using a DC voltage (Ref DC) so as to produce the form of the first modulation signal;

• transmitting said first modulation signal to a first amplifier (1) so as to produce square shaped RF pulses, transmitting said square shaped RF pulses to a second amplifier (7);

• generating a second modulation signal having a form that is substantially identical to the signal to be amplified and applying it to the second amplifier (7), said second amplifier (7) receiving said square shaped or substantially square shaped pulses coming from the first amplifier (1) and receiving the second modulation signal generated by a digital analogue converter (30) on the basis of first modulation tables (29) and receiving information relating to the amplitude of said second modulation signal on the basis of second tables (8) selected by a Pnormal/Preduced control signal (PNR) so as to produce at the output of said second amplifier (7) a signal having the form of RF pulses, the peak power of which has two values that are fixed as a function of the frequency, said signal being transmitted to a power controlled stage comprising a third amplifier (20);

• generating a signal with a peak power level and controlled width and applying it to the signal coming from the amplification step having the form of RF pulses, said peak power level controlled width signal being a third modulation signal resulting from the processing of the RF signal detected at the output of the amplifier (20) by a detector (21) and transmitted to a video amplifier (22), the gain of which is controlled by a digital potentiometer with a series control bus to provide the frequency and temperature compensation of the RF amplifier, the signal at the output of the video amplifier (22) being transmitted to a peak detector (24) and then to a levels discriminator (25) that transmits on the basis of a setpoint value "Ref DC" the peak power information to a processing-control device (26) that develops a synchronized incrementation or decrementation command as a function of said Pnormal/Preduced signal (PNR) and the third modulation signal using said incrementation or decrementation command and using the modulation tables (29) via a digital potentiometer (27).

**7.** The method according to claim 6, **characterised in that** the RF output power is dependent on the gain of the video amplifier, which is controlled by its gain command coming from a digitised fable (29) that is indexed by frequency, temperature and PNR,

$$P_{peak} = \left( \frac{\text{setpoint}}{A \times K} \right)^2$$

wherein K: varies according to the frequency and temperature sensitivity of the detection system;

A: is the video amplifier gain (22) that is controlled by the system and developed from a digitised table that is indexed by frequency, temperature and PNR, the setpoint value is realised using a voltage reference.

**Patentansprüche**

**1.** Vorrichtung zum Regeln von wenigstens zwei Spitzenleistungspegeln für einen im Impulsmodus arbeitenden Verstärker, die wenigstens die folgenden Elemente umfasst:

eine Vormodulationsstufe, die wenigstens Folgendes beinhaltet:

• eine erste Verstärkerstufe, die wenigstens einen ersten Verstärker (1) mit einer Impuls-Drain-Versorgung ($2_1$) umfasst und die Aufgabe hat, ein erstes verstärktes RF-Signal zu erzeugen, wobei der Verstärkungsfaktor des ersten Verstärkers (1) durch ein erstes Modulationssignal geregelt wird, das von zwei ersten digitalen Tabellen (5) erzeugt wird, die in Abhängigkeit von einer Sendefrequenz (FREQ) adressiert werden, und ein Pnormal/Preduced-Steuersignal (PNR) durch eine erste Verarbeitungsvorrichtung (6), wobei die Amplitude des ersten Modulationssignals durch ein digitales Potiometer (4) verwaltet wird, wobei die Form des ersten Signals über eine Gleichspannungsquelle (DC) erzeugt wird, wobei die erste Verstärkerstufe einen Eingang umfasst, der so ausgelegt ist, dass er das Modulationssignal (1) empfängt, wobei das vom ersten Verstärker (1) verstärkte RF-Signal die Form von rechtekkigen RF-Impulsen hat, wobei die Impulse übertragen werden zu:

einer zweiten Verstärkerstufe, die einen zweiten Verstärker (7) mit einer Impuls-Drain-Versorgung ($2_2$) umfasst, wobei der Verstärkungsfaktor des zweiten Verstärkers (7) durch ein zweites Modulationssignal geregelt wird, das von eine Digital-Analog-Wandler (30) von Modulationstabellen (29) und von zweiten digitalen Tabellen (8) erzeugt wird, die vom Pnormal/Preduced-Steuersignal (PNR) über ein erstes digitales Potentiometer (10) gewählt werden, wobei das digitale Potentiometer (10) so ausgelegt ist, dass es die Amplitude des zweiten Modulationssignals variiert, wobei der zweite Verstärker (7) ein Ausgangssignal in Form von RF-Impulsen erzeugt, deren Spitzenleistung zwei feste Werte in Abhängigkeit von der Frequenz hat, wobei die RF-Impulse einer leistungskontrollierten Stufe übertragen werden,

wobei die leistungskontrollierte Stufe wenigstens Folgendes umfasst:

• einen variablen RF-Verstärker (20), der so ausgelegt ist, dass er das Ausgangssignal vom zweiten Verstärker (7) empfängt, wobei der Verstärkungsfaktor des RF-Verstärkers (20) von eine dritte Modulationssignal geregelt wird, das von der Verarbeitung eines RF-Signals am Ausgang des RF-Verstärkers (20) resultiert, wobei der Ausgang des RF-Verstärkers (20) mit eine Koppler und einem Detektor (21) mit eine Ausgang verbunden ist, der mit eine Videoverstärker (22) gekoppelt ist, dessen Verstärkungsfaktor von einem digitalen Potentiometer mit seriellem Steuerbus gesteuert wird, um die Frequenz- und Temperaturkompensation des RF-Verstärkers (20) zu gewährleisten, ein Ausgang des Videoverstärkers (22) mit eine Spitzendetektor (24) verbunden ist, Ausgang mit eine Pegeldiskriminator (25) verbunden ist, der einen Eingang hat, der so ausgelegt ist, dass er einen Sollwert "Ref DC" empfängt, und einen Ausgang, der so ausgelegt ist, dass er die Spitzenleistungsinformationen zu einer Verarbeitungs-Regelvorrichtung (26) überträgt, wobei die Verarbeitung-Regelvorrichtung so ausgelegt ist, dass sie einen synchronisierten Inkrementations- oder Dekrementationsbefehl entwickelt und überträgt, der in Abhängigkeit von dem Pnormal/Preduced-Signal (PNR) zu einen ersten Eingang eines zweiten digitalen Potentiometers (27) adressiert wird, wobei das zweite digitale Potentiometer (27) einen zweiten Eingang hat, der so ausgelegt ist, dass er ein Modulationssignal empfängt, das von Modulationstabellen (29) erzeugt wird, die von eine diskreten Pnormal/Preduced-Signal gewählt werden, das mit dem identisch ist, das in der vorherigen Stufe verwendet wurde und das das dritte Modulationssignal am Ausgang hat.

2. Vorrichtung nach Anspruch 1, **dadurch gekennzeichnet, dass** die RF-Ausgangsleistung vom Verstärkungsfaktor des Videoverstärkers abhängig ist, der durch seinen Verstärkungsbefehl geregelt wird, der von einer Tabelle (29) kommt, digitalisiert im Hinblick auf Frequenz, Temperatur und PNR,

$$P_{\text{Spitze}} = \left( \frac{\text{Sollwert}}{A \times K} \right)^2$$

wobei

K: gemäß der Frequenz- und Temperaturempfindlichkeit des Detektionssystems variiert;

A: der Videoverstärker-Verstärkungsfaktor (22) ist, der vom System geregelt und auf der Basis einer digitalisierten Tabelle entwickelt wird, die im Hinblick auf Frequenz, Temperatur und PNR indexiert wird, wobei der Sollwert mit Hilfe einer Spannungsreferenz bestimmt wird.

3. Vorrichtung nach Anspruch 1, **dadurch gekennzeichnet, dass** die erste Verstärkungsstufe einen LDMOS-Transistor umfasst, der in Klasse AB mit einer Impuls-Drain-Versorgung verwendet wird.

4. Vorrichtung nach Anspruch 1, **dadurch gekennzeichnet, dass** die zweite Verstärkungsstufe einen LDMOS-Transistor umfasst, der in Klasse AB mit einer Impuls-Drain-Versorgung verwendet wird.

5. Vorrichtung nach Anspruch 1, **dadurch gekennzeichnet, dass** der Verstärkungsfaktor der zweiten Verstärkerstufe durch eine variable amplitudenmodulierte Spannung geregelt wird.

6. Verfahren zum Regeln oder Erzeugen von wenigstens zwei Spitzenleistungspegeln in einer im Impulsmodus arbeitenden Verstärkungskette, wobei die Verstärkungskette eine erste Verstärkerstufe und eine zweite Verstärkerstufe umfasst, das wenigstens die folgenden Schritte beinhaltet:

• Entwickeln eines ersten Modulationssignals mit einer Amplitude, die unter Verwendung einer variablen Gleichspannung geregelt wird, die auf der Basis von zwei digitalen Tabellen (5) erzeugt wird, adressiert in Abhängigkeit von einer Sendefrequenz und eine Pnormal/Preduced-Steuersignal (PNR), unter Verwendung einer Gleichspannung (Ref DC), um die Form des ersten Modulationssignals zu erzeugen;

• Übertragen des ersten Modulationssignals zu eine ersten Verstärker (1), um rechteckige RF-Impulse zu erzeugen, Übertragen der rechteckigen RF-Impulse zu eine zweiten Verstärker (7);

• Erzeugen eines zweiten Modulationssignals mit einer Form, die mit dem zu verstärkenden Signal im Wesentlichen identisch ist, und Anlegen desselben an den zweiten Verstärker (7), wobei der zweite Verstärker (7) die vom ersten Verstärker (1) kommenden rechteckigen oder im Wesentlichen rechteckigen Impulse empfängt und das zweite Modulationssignal empfängt, das von einem Digital-Analog-Wandler (30) auf der Basis von ersten Modulationstabellen (29) empfangen wird, und eine Information über die Amplitude des zweiten Modulationssignals von zweiten Tabellen (8) empfängt, die von eine Pnormal/Preduced-Steuersignal (PNR) ausgewählt sind, um am Ausgang des zweiten Verstärkers (7) ein Signal in Form von RF-Impulsen zu erzeugen, deren Spitzenleistung zwei Werte hat, die in Abhängigkeit von der Frequenz festgelegt sind, wobei das Signal zu einer leistungskontrollierten Stufe übertragen wird, die einen dritten Verstärker (20) umfasst;

• Erzeugen eines Signals mit einem Spitzenleistungspegel und und geregelter Breite und Anlegen desselben an das von der zweiten Verstärkungsstufe kommende Signal in Form von RF-Impulsen, wobei der Spitzenleistungspegel mit geregelter Breite ein drittes Modulationssignal ist, das von der Verarbeitung des RF-Signals resultiert, das am Ausgang des Verstärkers (20) von eine Detektor (21) detektiert und zu eine Videoverstärker (22) übertragen wird, dessen Verstärkungsfaktor von einem digitalen Potentiometer mit eine seriellen Steuerbus gesteuert wird, um die Frequenz- und Temperaturkompensation des RF-Verstärkers bereitzustellen, wobei das Signal am Ausgang des Videoverstärkers (22) eine Spitzendetektor (24) und dann eine Pegeldiskriminator (25) übertragen wird, der auf der Basis eines Sollwertes "Ref DC" die Spitzenleistungsinformationen einer Verarbeitungs-Regelvorrichtung (26) überträgt, die einen synchronisierten Inkrementations- oder Dekrementationsbefehl in Abhängigkeit vom Pnormal/Preduced-Signal (PNR) entwickelt, und Erzeugen des dritten Modulationssignals mit dem Inkrementations- oder Dekrementationsbefehl und unter Verwendung der Modulationstabellen (29) über ein digitales Potentiometer (27).

7. Verfahren nach Anspruch 6, **dadurch gekennzeichnet, dass** die RF-Ausgangsleistung vom Verstärkungsfaktor des Videoverstärkers abhängig ist, der mit seine Verstärkungsbefehl geregelt wird, der von einer digitalisierten Tabelle (29) kommt, die im Hinblick auf Frequenz, Temperatur und PNR indexiert ist,

$$P_{\text{Spitze}} = \left( \frac{\text{Sollwert}}{A \times K} \right)^2$$

wobei

K: gemäß der Frequenz- und Temperaturempfindlichkeit des Detektionssystems variiert;

A: der Videoverstärker-Verstärkungsfaktor (22) ist, der vom System und von digitalisieren Tabelle entwickelt wird, die im Hinblick auf Frequenz, Temperatur und PNR indexiert ist,

wobei der Sollwert mit Hilfe einer Spannungsreferenz bestimmt wird.

FIG.1

synchro

cde alim

cde PN/PR

modulation
étage 1

modulation
étage 2

Table

Table

$(PN - PR)/2$

Pour étage 1

$(PN - PR)$

Pour étage 2

$(PN - PR)$

FIG.2A

EP 1 938 452 B1

Traitement puissance crête :

synchro

modulation

Table PN
PR

Pour étage 3

P trop forte          P OK          P trop faible          P OK          P OK

Traitement largeur :

synchro

modulation

Table PN
PR          Table n          Table n+1

Pour étage 3

trop
large          largeur OK          trop
faible          largeur OK          largeur OK

FIG.2B

EP 1 938 452 B1

FIG.3

**EP 1 938 452 B1**

**Documents brevets cités dans la description**

• US 4237555 A